# EUROPÄISCHE PATENTSCHRIFT

(11) **EP 2 596 580 B1**
(45) Veröffentlichungstag und Bekanntmachung des Hinweises auf die Patenterteilung: **03.09.2014**
(21) Anmeldenummer: 11767904.3
(22) Anmeldetag: 18.07.2011
(51) Int. Cl.: H02P 8/12, H02P 25/22

(54) **VERFAHREN UND SCHALTUNGSANORDNUNG ZUR STROMREGELUNG BEI 3-PHASEN-MOTOREN**
METHOD AND CIRCUIT ASSEMBLY FOR CURRENT CONTROL IN 3-PHASE MOTORS
PROCÉDÉ ET CIRCUIT POUR RÉGULER LE COURANT DE MOTEURS TRIPHASÉS

(30) Priorität: 17.07.2010 DE 102010036473
(43) Veröffentlichungstag der Anmeldung: 29.05.2013
(73) Patentinhaber: Trinamic Motion Control GmbH & Co. KG, 22769 Hamburg (DE)
(72) Erfinder: LARSSON, Lars, 20249 Hamburg (DE); DWERSTEG, Bernhard, 25462 Rellingen (DE)
(74) Vertreter: Heun, Thomas
(86) Internationale Anmeldenummer: PCT/DE2011/075171
(87) Internationale Veröffentlichungsnummer: WO 2012/010169

(56) Entgegenhaltungen:
- CN-A- 1 073 059
- DE-A1-102006 001 915
- JP-A- 2001 231 299
- JP-A- 2002 281 788

## Beschreibung

Die Erfindung betrifft ein Verfahren und eine Schaltungsanordnung zur Regelung des Motorstroms bei einem elektrischen Motor mit drei oder mehr Phasen, insbesondere einem Schrittmotor mit drei oder mehr Phasen, mittels eines Chopper-Verfahrens.

Es ist bekannt, bei 2-Phasen-Motoren und insbesondere 2-Phasen-Schrittmotoren mittels Chopper-Verfahren aus einer zugeführten Motor-Versorgungspannung für jede der beiden Motorspulen die in diese entsprechend einer Stromvorgabe (Spulen-Sollstrom) jeweils einzuprägende Stromrichtung, Stromhöhe und Stromform (im Mikroschrittbetrieb üblicherweise eine sinus- bzw. cos-Form) mittels PWM-Strompulsen zu erzeugen, um damit den Rotor des Motors anzutreiben. Als Beispiel sei der Schrittmotor-Antrieb in JP 2 002 281 788 genannt.

Dabei werden drei verschiedene Spulenstromphasen unterschieden, die durch das Chopper-Verfahren aktiviert werden:
In der ON-Phase wird der Spulenstrom in eine Spule jeweils in Richtung der momentan vorgegebenen Polarität bzw. Richtung des Spulenstroms aktiv durch die Spule getrieben, so dass der Spulenstrombetrag relativ schnell und kontinuierlich ansteigt (Einschaltperiode). Die durch eine ON-Phase eingeprägte Spulenstromrichtung ist also gleich der momentanen Polarität bzw. Richtung des Spulenstroms.

Die Polarität des Spulenstromes ist dabei im Falle eines sinusförmigen Spulenstromes z.B. positiv im ersten und zweiten Quadranten und negativ im dritten und vierten Quadranten.

In der Fast-Decay-(FD-) Phase wird der Spulenstrom entgegen der gerade vorgegebenen Polarität des Spulenstroms durch Umpolen der Spule und Rückspeisung des Spulenstroms in die Stromversorgung aktiv abgebaut, d.h. die Spulenstromrichtung ist entgegengesetzt zu der Polarität des Spulenstromes. Die FD-Phase dient dazu, den Spulenstrom insbesondere in den Phasen fallenden Spulenstrombetrages (d.h. während des zweiten und vierten Quadranten eines sinusförmigen Spulenstroms) relativ schnell abzubauen und zu verhindern, dass die Stromvorgabe insbesondere durch die Gegen-EMK verfälscht wird.

Als dritte Spulenstromphase des Chopper-Betriebes ist die Rezirkulationsphase oder Slow-Decay-(SD-) Phase zu nennen, in der die Spule nicht aktiv angesteuert sondern kurzgeschlossen bzw. gebrückt wird, so dass der Spulenstrom aufgrund des Innenwiderstandes der Spule und der Gegen-EMK nur allmählich (d.h. langsamer als während der FD-Phasen) betragsmäßig abfällt.

Diese drei Spulenstromphasen werden durch das Chopper-Verfahren zeitlich so aktiviert, bemessen und kombiniert, dass der tatsächliche Spulenstrom über seinen gesamten (z.B. sinusförmigen) Verlauf, also während der steigenden und der fallenden Stromphasen, möglichst zeitnah und genau einer Stromvorgabe (Spulen-Sollstrom) folgt und insbesondere durch die durch den Rotor in den Motorspulen gegeninduzierte Spannung (Gegen-EMK) nicht (wesentlich) verändert wird. Dazu ist es erforderlich, den tatsächlichen Strom durch jede der beiden Spule in geeigneter Weise zu messen oder zu bestimmen.

Im Gegensatz zu 2-Phasen-Schrittmotoren ist jedoch bei 3-Phasen-Schrittmotoren die Ansteuerung der einzelnen, jeweils um 120° räumlich in Relation zu dem Rotor gegeneinander versetzten Motorspulen im Allgemeinen elektrisch voneinander entkoppelt nicht möglich (abweichend nur in der DE 10 2007 040 166), da diese innerhalb des Motors in Dreieck- oder Sternschaltung oder anders miteinander verbunden und somit nicht sämtliche (insgesamt sechs) Anschlüsse aller (drei) Spulen in elektrisch voneinander isolierter Weise nach außen geführt sind. 3-Phasen-Schrittmotoren werden deshalb üblicherweise mit einem gesteuerten Chopper, der die drei zur Verfügung stehenden äußeren Anschlüsse U, V, W des Motors jeweils mit hinsichtlich ihrer Phase um 120° gegeneinander versetzten PWM-Strompulsen beaufschlagt, angesteuert, wie es in ähnlicher Weise zur Ansteuerung von 3-Phasen BLDC-Motoren bekannt ist. Die Austeuerung eines solchen dreiphasigen, elektronisch kommentierten Motors wird z.B. in der DE 102 006 001 915 beschrieben.

Die einzelnen Spulen des Motors sehen bei einer solchen Ansteuerung dann jeweils eine effektive Ansteuerspannung, die der Differenz zwischen den zeitlichen Dauern der jeweiligen PWM-Strommuster an den beiden Anschlüssen der betreffenden Motorspule entspricht. Der Motor wird somit mit einer effektiven Ansteuerspannung angesteuert und kann dadurch sehr präzise im Bereich niedriger Geschwindigkeiten gedreht werden. Zu diesem Zweck werden die PWM-Strompulse sinusförmig moduliert, sodass ein sinusförmiger Stromverlauf in den Motorspulen erzeugt wird, d.h. in die drei Anschlüsse U, V und W des Motors werden Ströme eingespeist, die eine Sinusform haben und relativ zueinander die Phasen sin(x), sin(x+120°) bzw. sin(x-120°) aufweisen.

Es hat sich jedoch gezeigt, dass der Motor zuweilen sehr unruhig läuft, sobald bei einem solchen Betrieb die Drehzahl des Motors in die Nähe der mechanischen (Eigen-) Resonanzfrequenz des Motors kommt. Eine wesentliche Ursache liegt offenbar darin, dass die durch die Resonanzen entstehende, nicht mehr sinusförmige Gegen-EMK des Motors dann in die Größenordnung der Ansteuerspannungen an den Motorspulen kommen kann und diese zum Teil aufhebt. Diese durch die resonanzbedingten Schwingungen entstehende Gegen-EMK subtrahiert sich von den Ansteuerspannungen, sodass die resultierenden Spulenströme stark von dem für einen optimalen Motorbetrieb notwendigen sinusförmigen Verlauf abweichen können. Da der Rotor des Motors durch die Magnetfelder und damit durch die Spulenströme gesteuert wird, kann er wiederum nicht mehr genau genug den vorgegebenen sinusförmigen Ansteuerspannungen folgen.

Zwar ist es denkbar, mittels eines Reglers, z.B. eines PID-Reglers, die Ansteuerspannungen an den Motorspulen in Abhängigkeit von der Gegen-EMK so nachzuregeln, dass die Spulenströme möglichst sinusförmig bleiben. Die Verwendung eines solchen übergeordneten Reglers hat jedoch neben dem höheren Schaltungsaufwand und dessen hoher Komplexität auch den Nachteil, dass die Parametrierung des Reglers kritisch ist und ggf. motorspezifische Parameter erfordert bzw. von diesen abhängig ist.

Eine Aufgabe, die der Erfindung zugrunde liegt, besteht deshalb darin, ein Verfahren und eine Schaltungsanordnung zur Regelung des Motorstroms bei einem elektrischen 3-Phasen-Motor, insbesondere einem 3-Phasen-Schrittmotor, zu schaffen, mit dem/der die oben genannten Nachteile vermieden werden und insbesondere kein übergeordneter Regler zu dem oben genannten Zweck erforderlich ist.

Eine weitere Aufgabe, die der Erfindung zugrunde liegt, besteht darin, ein Verfahren und eine Schaltungsanordnung zur Regelung des Motorstroms bei einem elektrischen 3-Phasen-Motor, insbesondere einem 3-Phasen-Schrittmotor, zu schaffen, mit dem/der mit relativ geringem zusätzlichen Schaltungsaufwand ein ruhiger Motorlauf auch bei höheren und hohen Motordrehzahlen realisiert werden kann.

Gelöst wird diese Aufgabe gemäß Anspruch 1 mit einem Verfahren zur Regelung des Motorstroms bei einem elektrischen 3-Phasen-Motor, insbesondere einem 3-Phasen-Schrittmotor, mit einem ersten, einem zweiten und einem dritten Motoranschluss, wobei zyklisch alternierend jeweils eine erste, eine zweite und eine dritte Chopper-Phase aktiviert wird, während der der Motor einerseits mit dem ersten, dem zweiten bzw. dem dritten Motoranschluss und andererseits mit den beiden jeweils anderen, miteinander verbundenen Motoranschlüssen zwischen eine Versorgungsspannung und Masse geschaltet ist, und wobei zumindest während zwei der drei Chopper-Phasen ein für den betreffenden ersten bzw. zweiten bzw. dritten Motoranschluss zugeführter Sollstrom mittels eines Chopper-Verfahrens in diesen Motoranschluss eingeprägt wird.

Die Aufgabe wird ferner gemäß Anspruch 10 mit einer Schaltungsanordnung zur Regelung des Motorstroms bei einem elektrischen 3-Phasen-Motor, insbesondere einem 3-Phasen-Schrittmotor, mit einem ersten, einem zweiten und einem dritten Motoranschluss gelöst, die eine durch einen Chopper (CH) angesteuerte Treiberschaltung (DR) aufweist, mit der zyklisch alternierend zwischen mindestens zwei Chopper-Phasen umgeschaltet wird, wobei während jeder Chopper-Phase in jeweils einen der Motoranschlüsse mittels eines Chopper-Verfahrens ein einem zugeführten Motor-Sollstrom für diesen Motoranschluss entsprechender Motorstrom eingeprägt wird, wobei die beiden anderen Motoranschlüsse durch die Treiberschaltung (DR) miteinander verbunden sind.

Mit dem erfindungsgemäßen Verfahren und der erfindungsgemäßen Schaltungsanordnung ist eine robuste und einfache Steuerung der Motorströme möglich, wobei aufgrund des Konstantstrombetriebes Eigenresonanzen des Motors gut bedämpft werden können.

Aufgrund der Einfachheit des Verfahrens ist der Aufwand an digitalen Schaltelementen sowie Komponenten zur Signalerfassung relativ gering.

Die erfindungsgemäße Schaltungsanordnung ist deshalb zur Integration in insbesondere solche integrierten Schaltungen geeignet, die Hochspannungstechnologien nutzen müssen, um die direkte Ansteuerung von Motoren oder von Leistungstransistoren, die wiederum einen Motor ansteuern, zu ermöglichen. Solche integrierten Schaltungen haben nämlich aufgrund ihrer höheren Strukturbreiten nur begrenzte Möglichkeiten zur ökonomischen Integration größerer Digitalteile. Somit kann also auch ein für die Massenproduktion geeigneter Komplett-Baustein realisiert werden.

Die Unteransprüche haben vorteilhafte Weiterbildungen der Erfindung zum Inhalt.

Weitere Einzelheiten, Merkmale und Vorteile der Erfindung ergeben sich aus der folgenden Beschreibung von bevorzugten, beispielhaften Ausführungsformen anhand der Zeichnung. Es zeigt:
- Fig. 1: Schaltbilder mit verschiedenen Spulenstromphasen in einer Motorspule während des Chopperbetriebes;
- Fig. 2: Schaltbilder verschiedener Chopper-Phasen zur zyklischen Ansteuerung der Motorspulen gemäß der Erfindung;
- Fig. 3: eine Darstellung von gemessenen Spulenstromverläufen mit Verzerrungen;
- Fig.4: eine Darstellung von gemessenen Spulenstromverläufen bei Anwendung einer Hysterese; und
- Fig. 5: ein Prinzipschaltbild einer Schrittmotor-Ansteuereinheit mit den zur Durchführung des erfindungsgemäßen Verfahrens wesentlichen Komponenten.

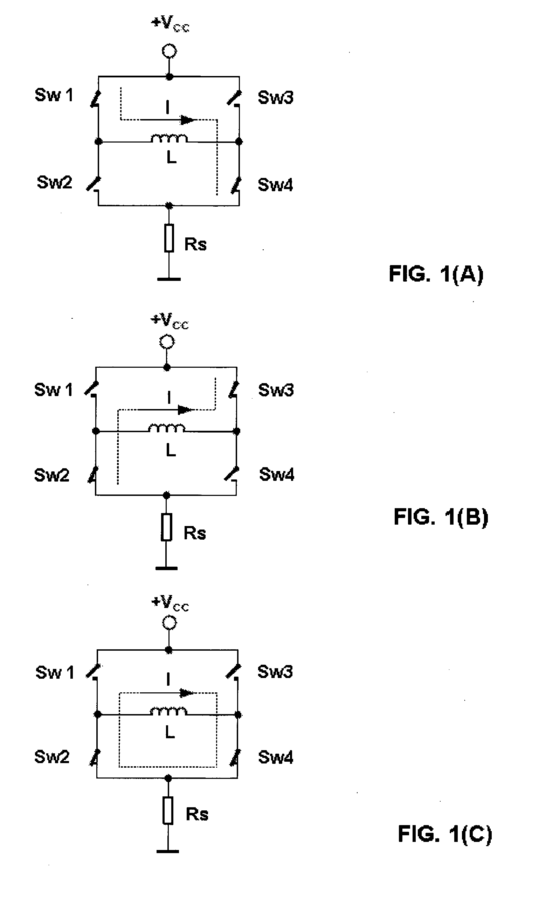

Zunächst sollen die drei eingangs genannten Spulenstromphasen für eine der Motorspulen näher erläutert werden. Die drei Spulenstromphasen sind schematisch in Figur 1(A), Figur 1(B) bzw. Figur 1(C) angedeutet. Diese drei Figuren zeigen jeweils eine Brückenschaltung aus einem ersten bis vierten Schalter Sw1, Sw2, Sw3, Sw4, wobei ein erster und ein zweiter Schalter Sw1, Sw2 sowie ein dritter und ein vierter Schalter Sw3, Sw4 jeweils in Reihe geschaltet und die beiden Reihenschaltungen parallel miteinander verbunden sind. Die Motorspule L ist mit den Mittelpunkten der Brückenzweige verbunden. Der Fußpunkt der Brückenschaltung ist typischerweise über einen Messwiderstand Rs zur Messung des tatsächlichen Spulenstroms mit Masse verbunden, während der Kopf der Brückenschaltung an eine Spannungs- bzw. Stromversorgung Vcc angeschlossen ist.

Figur 1(A) zeigt die Schalterstellungen und die daraus resultierende Richtung des Stromflusses I durch die Spule L während der oben genannten ersten Spulenstromphase (ON-Phase), in der diese Richtung die gleiche ist wie die vorgegebene Richtung bzw. Polarität des Spulenstroms, wobei der erste und der vierte Schalter Sw1, Sw4 geschlossen und der zweite und der dritte Schalter Sw2, Sw3 geöffnet sind.

Figur 1(B) zeigt die Schalterstellungen und die daraus resultierende Umpolung der Spule L sowie die Rückspeisung des Spulenstroms I in die Spannungsversorgung Vcc, d.h. entgegen der vorgegebenen Richtung bzw. Polarität des Spulenstroms (die hier die gleiche ist wie in Figur 1(A)) während der oben genannten zweiten Spulenstromphase oder Fast-Decay-Phase (FD-Phase), in der der erste und der vierte Schalter Sw1, Sw4 geöffnet und der zweite und der dritte Schalter Sw2, Sw3 geschlossen sind.

Schließlich zeigt Figur 1(C) die dritte Spulenstromphase oder Slow-Decay-Phase (SD-Phase), bei der die Spule L kurzgeschlossen oder gebrückt ist, d.h. der zweite und der vierte Schalter Sw2, Sw4 sind geschlossen, während der erste und der dritte Schalter Sw1, Sw3 geöffnet sind (oder entsprechend umgekehrt), so dass sich der in der Spule L fließende Strom I entsprechend dem Innenwiderstand der Spule L allmählich abbaut, d.h. rezirkuliert.

Sofern die einzelnen Spulen des Motors jeweils z. B. mit sinusförmig verlaufenden Spulenströmen angesteuert werden (wobei die einzelnen Spulenströme eine dem räumlichen Versatz der Motorspulen um den Rotor entsprechende Phasenverschiebung zueinander aufweisen), können Phasen steigenden Spulenstrombetrages (d.h. während des ersten und dritten Quadranten des sinusförmigen Spulenstroms) und Phasen fallenden Spulenstrombetrages (d.h. während des zweiten und vierten Quadranten des sinusförmigen Spulenstroms) in den Spulen unterschieden werden. Jeder dieser Stromquadranten wird durch das Chopper-Verfahren in eine durch die Chopperfrequenz (d.h. die Frequenz, mit der sich der Zyklus ON-FD-SD gemäß Figur 1 wiederholt) bestimmte, geeignete Anzahl von ON-, FD- und ggf. SD-Phasen so unterteilt und realisiert, dass der tatsächliche Spulenstrom einem vorgegebenen, im Allgemeinen sinusförmigen Spulen-Sollstrom möglichst genau folgt.

Wie oben bereits erwähnt wurde, ist jedoch bei einem 3-Phasen-Motor eine unabhängige und voneinander entkoppelte Ansteuerung der einzelnen Spulen des Motors und damit die in Figur 1 gezeigte unabhängige Realisierung der drei Spulenstromphasen im Allgemeinen nicht möglich. Ein 3-Phasen-Motor hat üblicherweise drei äußere Motoranschlüsse U, V, W, die auf unterschiedliche Weise mit den Anschlüssen der drei Motorspulen verbunden sein können, je nachdem ob diese Spulen in der bekannten Stern- oder Dreieck-Schaltung oder auf andere Weise verschaltet sind.

Unabhängig von dieser Motor-internen Verschaltung werden mit dem erfindungsgemäßen Verfahren bzw. der erfindungsgemäßen Schaltungsanordnung also nicht die einzelnen Motorspulen, sondern die zur Verfügung stehenden äußeren Anschlüsse U, V, W des Motors in der Weise beschaltet und mit dem oben beschriebenen Chopper-Verfahren mit Strom beaufschlagt, dass sich mittels der ON-, FD- und ggf. SD-Phasen an diesen drei äußeren Anschlüssen U, V, W die gewünschten bzw. vorgegebenen Motor-Sollströme IsU, IsV, IsW ergeben, die wiederum die Drehgeschwindigkeit und die Drehrichtung des Motors bestimmen.

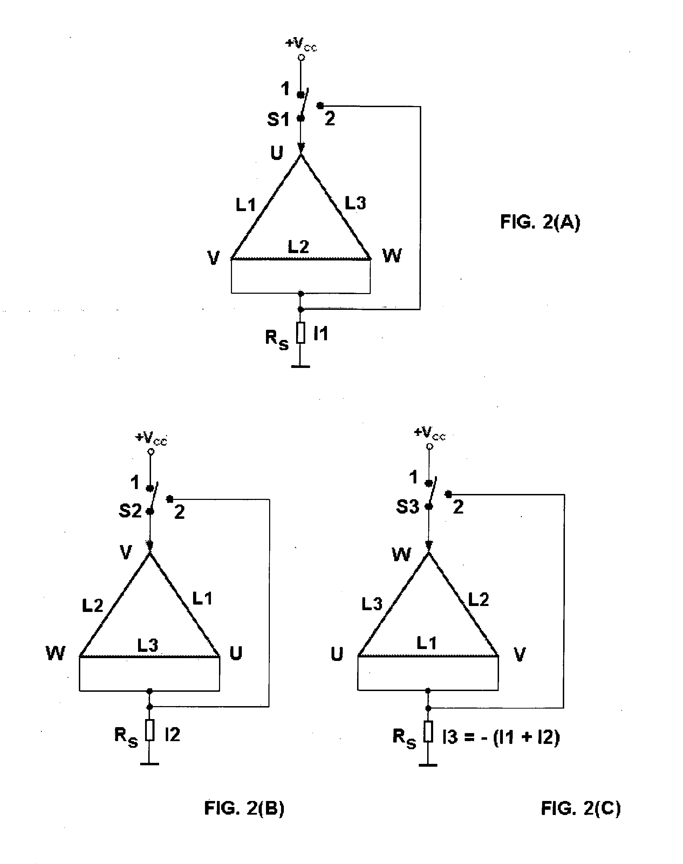

Das erfindungsgemäße Prinzip, mit dem die drei oben beschriebenen Spulenstromphasen ON, FD und ggf. SD bei einem 3-Phasen-Motor realisiert werden, soll zunächst anhand der Figur 2 erläutert werden.

Die Figuren 2(A), 2(B) und 2(C) zeigen schematisch jeweils einen 3-Phasen-Motor mit drei äußeren Motoranschlüssen U, V, W und drei Motorspulen L1, L2, L3, die hier in Dreieck-Schaltung geschaltet sind. Wie oben bereits erwähnt wurde, gilt diese Figur jedoch auch für eine Stern-Schaltung oder eine andere interne Verschaltung der Motorspulen, da die Dreieckschaltung als Ersatzschaltbild einer Stern- oder anderer Verschaltungen angesehen werden kann.

Zur Vereinfachung der weiteren Erläuterungen sei angenommen, dass sich zwischen dem ersten und dem zweiten Motoranschluss U, V eine erste Spule L1, zwischen dem zweiten und dem dritten Motoranschluss V, W eine zweite Spule L2 und zwischen dem dritten und dem ersten Motoranschluss W, U eine dritte Spule L3 des Motors befindet.

Figur 2(A) zeigt eine erste Chopper-Phase, bei der der erste Motoranschluss U über einen ersten Schalter S1 mit der (positiven) Versorgungspannung Vcc und der zweite und der dritte Motoranschluss V, W miteinander verbunden sind und über einen Messwiderstand Rs an Masse bzw. einem Bezugspotential anliegen. Dabei fließt zwischen der Versorgungspannung Vcc und Masse ein erster Strom I1. Wenn der erste Schalter S1 aus der dargestellten ersten Schaltstellung 1 in die zweite Schaltstellung 2 umgeschaltet wird, so wird der erste Motoranschluss U von der Versorgungsspannung Vcc getrennt und mit den beiden anderen Motoranschlüssen V, W verbunden.

Figur 2(B) zeigt eine zweite Chopper-Phase, bei der der zweite Motoranschluss V über einen zweiten Schalter S2 mit der Versorgungspannung Vcc und der erste und der dritte Motoranschluss U, W miteinander verbunden sind und über den Messwiderstand Rs an Masse anliegen, wobei zwischen der Versorgungspannung Vcc und Masse ein zweiter Strom I2 fließt. Durch Umschalten des zweiten Schalters S2 aus der dargestellten ersten Schaltstellung 1 in die zweite Schaltstellung 2 wird der zweite Motoranschluss V von der Versorgungsspannung Vcc getrennt und mit den beiden anderen Motoranschlüssen U, W verbunden.

Figur 2(C) zeigt eine dritte Chopper-Phase, bei der der dritte Motoranschluss W über einen dritten Schalter S3 mit der Versorgungspannung Vcc verbunden ist, während der erste und der zweite Motoranschluss U, V miteinander verbunden und über den Messwiderstand Rs an Masse geführt sind, sodass zwischen der Versorgungspannung Vcc und Masse ein dritter Strom 13 fließt. Auch hierbei kann durch Umschalten des dritten Schalters S3 aus der dargestellten ersten Schaltstellung 1 in die zweite Schaltstellung 2 der dritte Motoranschluss W von der Versorgungsspannung Vcc getrennt und mit den beiden anderen Motoranschlüssen U, V verbunden werden.

Die Summe dieser drei Ströme I1, I2, I3 ist null, da keine weiteren Motorspulenanschlüsse vorhanden sind. Somit brauchen also stets nur zwei der drei Ströme in der erfindungsgemäßen Weise eingestellt bzw. gesteuert zu werden, da sich zum Beispiel der dritte Strom I3 zu 13 = - (I1 + I2) ergibt. Damit kann also auch ein negativer Strom (im dritten und vierten Quadranten im Falle von sinusförmigen Spulenströmen) durch entsprechende Einstellung der beiden anderen Ströme mit den nachfolgend erläuterten ON- bzw. FD-Motorstromphasen gesteuert werden.

Alternativ zu der in Figur 2 gezeigten Verschaltung wäre es auch möglich (allerdings mit einem höherem Schaltungsaufwand verbunden), einen negativen Strom aus einem der Motoranschlüsse dadurch zu erzeugen, das die beiden anderen, miteinander verbundenen Motoranschlüsse mit der positiven Versorgungspannung Vcc und der betreffende dritte Motoranschluss mit Masse verbunden wird.

In dem Fall, in dem sich der erste, der zweite und der dritte Schalter S1, S2, S3 jeweils in der dargestellten ersten Schaltstellung 1 befindet, kann während der ersten, der zweiten und der dritten Chopper-Phase jeweils eine erfindungsgemäße ON- oder FD-Phase des Motors (Motorstromphase) realisiert werden. Diese Motorstromphasen sind in gleicher Weise definiert, wie die oben mit Bezug auf Figur 1 erläuterten Spulenstromphasen, wobei eine erfindungsgemäße SD-Phase durch Umschalten jeweils eines der Schalter S1, S2, S3 in die zweite Schaltstellung 2 realisiert wird, in der alle drei Motoranschlüsse U, V, W miteinander bzw. über den Messwiderstand Rs mit Masse verbunden sind.

Die erfindungsgemäßen ON-, FD- und SD-Phasen werden im Folgenden als Motorstromphasen oder äußere (ON-, FD- und SD-) Phasen in Abgrenzung zu den mit Bezug auf Figur 1 erläuterten Spulenstromphasen oder inneren (ON-, FD- und SD-) Phasen (weil auf die einzelnen Motorspulen bezogen) bezeichnet.

Eine ON-Motorstromphase oder äußere ON-Phase liegt also dann vor, wenn durch das Chopper-Verfahren in der an sich bekannten Weise in den ersten, den zweiten oder den dritten Motoranschluss U, V, W ein Strom eingeprägt wird, dessen Richtung mit der momentanen vorgegebenen Polarität oder Stromrichtung des Motor-Sollstroms für diesen Anschluss übereinstimmt.

Entsprechend ist eine FD-Motorstromphase oder äußere FD-Phase gegeben, wenn durch das Chopper-Verfahren in der an sich bekannten Weise über den ersten, den zweiten oder den dritten Motoranschluss U, V, W eine Rückspeisung des Spulenstroms in die Versorgungspannung und somit entgegen der Richtung der vorgegebenen Polarität oder Stromrichtung des Motor-Sollstroms für diesen Anschluss erfolgt.

Wenn schließlich einer der drei Schalter S1, S2, S3 aus der ersten in die zweite Schaltstellung 2 umgeschaltet wird, so befindet sich der Motor in einer SD-Motorstromphase oder äußeren SD-Phase.

Die oben mit Bezug auf Figur 1 beschriebenen Spulenstromphasen ON und FD werden somit zur erfindungsgemäßen Motorstromregelung durch die Motorstromphasen ON und FD während zumindest zwei der drei Chopper-Phasen gemäß Figur 2 ersetzt, d.h. an mindestens zwei der drei Motoranschlüssen U, V, W während mindestens zwei der drei zyklisch alternierend aktivierten Chopper-Phasen realisiert. Insgesamt existieren somit entsprechend den drei Motoranschlüssen U, V, W maximal drei verschiedene Chopper-Phasen, während denen der Motor jeweils in einer (äußeren) ON- oder einer FD-Phase (Schalterstellungen 1) betrieben werden kann. Zusammen mit den weiterhin möglichen SD-Phasen (Schalterstellungen 2) sind also insgesamt maximal sieben verschiedene Motorstromphasen (nämlich ON und FD an jedem Motoranschluss U, V, W und eine SD-Phase zwischen jeweils zwei Chopper-Phasen, bei der alle Motoranschlüsse U, V, W miteinander verbunden sind) möglich.

Der Vollständigkeit halber soll erwähnt werden, dass sich während jeder Motorstromphase die Motorspulen je nach ihrer inneren Verschaltung auch in einer bestimmten Spulenstromphase befinden. Mit der Benennung und Verschaltung der Spulen gemäß Figur 2 ergibt sich, dass sich während der ersten Chopper-Phase gemäß Figur 2(A) die zweite Spule L2, während der zweiten Chopper-Phase gemäß Figur 2(B) die dritte Spule L3 und während der dritten Chopper-Phase gemäß Figur 2(C) die erste Spule L1 in einer SD-Spulenstromphase befindet, da diese Spulen bzw. die betreffenden Motoranschlüsse jeweils kurzgeschlossen sind. Darüber hinaus befinden sich während jeder der drei Chopper-Phasen die jeweils beiden anderen Spulen in einer ON- bzw. einer FD-Spulenstromphase.

Die Reihenfolge der Aktivierung der drei Chopper-Phasen gemäß Figur 2(A), 2(B) bzw. 2(C), d.h. die Richtung, in der diese zyklisch alternierend aktiviert werden, wird vorzugsweise in Übereinstimmung mit der Drehrichtung des Motors gewählt, um auch bei hohen Drehzahlen eine sinnvolle Abfolge zu gewährleisten, die nicht etwa der Drehung des Motors entgegenwirkt. Auf diese Weise wird eine drehrichtungsunabhängige Symmetrie der Ansteuerung erreicht.

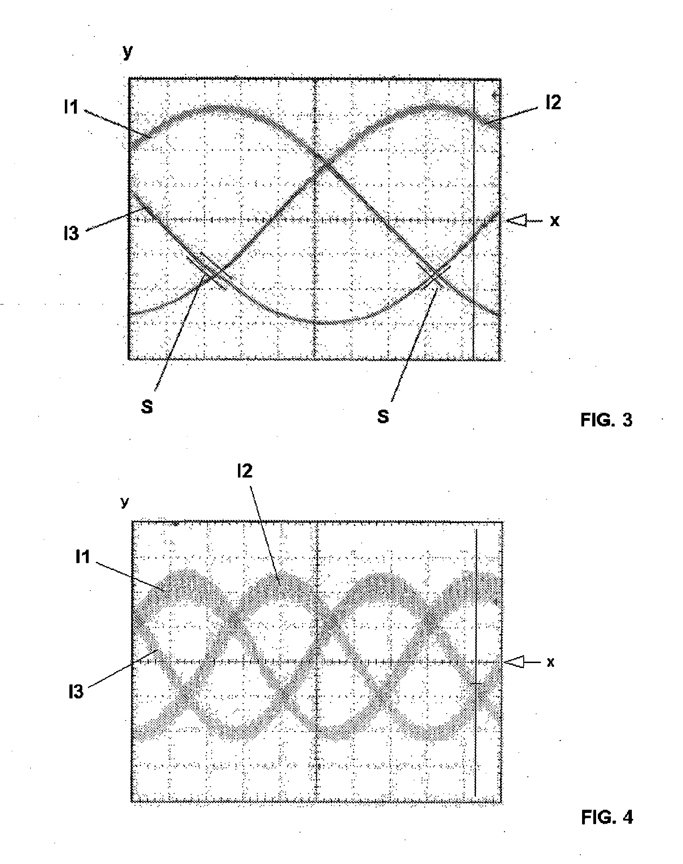

Vorzugsweise erfolgt das Umschalten von einer Chopper-Phase auf eine nächste Chopper-Phase mit einer Frequenz, die im Vergleich zu der Frequenz der sinusförmigen Sollströme IsU, IsV, IsW wesentlich höher ist, damit die durch die Chopper-Phasen eingeprägten Motorströme I1, I2, I3 möglichst exakt den Sollströmen IsU, IsV, IsW entsprechen. Damit dies auch bei einer hohen Drehzahl des Motors und damit einer entsprechend hohen Frequenz der Sollströme IsU, IsV, IsW gewährleistet ist, muss die Versorgungsspannung Vcc ausreichend hoch sein, so dass die Motorströme I1, I2, 13 während der jeweiligen Chopper-Phase entsprechend schnell erreicht werden. Im Beispiel der Figur 3 liegt diese Umschalt-Frequenz bei mehreren 10 kHz.

Die Motorstromphasen (ON, FD) während der Chopper-Phasen sowie ggf. die SD-Phasen zwischen zwei Chopper-Phasen werden durch das Chopper-Verfahren in an sich bekannter Weise zeitlich so aktiviert, bemessen und kombiniert, dass der jeweilige tatsächliche Motorstrom I1, I2 bzw. I3 während der jeweiligen Chopper-Phase und damit der jeweilige Motorstrom auch über seinen gesamten (z.B. sinusförmigen) Verlauf, also während der steigenden und der fallenden Stromphasen beider Polaritäten, möglichst zeitnah und genau dem jeweiligen Motor-Sollstrom IsU, IsV bzw. IsW folgt, wobei zu berücksichtigen ist, dass die Summe der drei Ströme I1, I2, I3 zumindest im Wesentlichen null ist. Dabei wird bevorzugt während einer Chopper-Phase durch das Chopper-Verfahren nur jeweils eine Motorstromphase (also entweder eine äußere ON- oder eine äußere FD-Phase) aktiviert. Ferner wird bevorzugt eine Chopper-Phase dann beendet und die nächste Chopper-Phase aktiviert, wenn die Motorstromphase in der betreffenden Chopper-Phase durch das Chopper-Verfahren beendet wird.

Die Frequenzen, Amplituden und Phasen der Motor-Sollströme IsU, IsV, IsW werden in bekannter Weise u. a. entsprechend der gewünschten Drehgeschwindigkeit und Drehrichtung des Motors sowie bestimmter Motorparameter usw. erzeugt und der erfindungsgemäßen Schaltungsanordnung zugeführt.

Zum Beispiel bedeutet dies, dass die in Figur 2(A) gezeigte erste Chopper-Phase beendet und auf die zweite Chopper-Phase gemäß Figur 2(B) umgeschaltet wird, wenn der erste Motorstrom I1 an dem Motoranschluss U den momentanen Sollstrom IsU zumindest im Wesentlichen (d.h. entsprechend den bekannten Kriterien für das Beenden einer ON- bzw. FD-Phase) erreicht hat. Entsprechend wird die in Figur 2(B) gezeigte zweite Chopper-Phase beendet und auf die dritte Chopper-Phase gemäß Figur 2(C) umgeschaltet, wenn der zweite Motorstrom I2 an dem Motoranschluss V den momentanen Sollstrom IsV zumindest im Wesentlichen (d.h. wie oben) erreicht hat. Schließlich wird die in Figur 2(C) gezeigte dritte Chopper-Phase beendet und wieder auf die erste Chopper-Phase umgeschaltet, wenn der dritte Motorstrom 13 an dem Motoranschluss W den momentanen Sollstrom IsW zumindest im Wesentlichen (d.h. wie oben) erreicht hat. Davon unberührt bleibt die Möglichkeit, dass durch das Chopper-Verfahren in an sich bekannter Weise zwischen zwei Chopper-Phasen noch jeweils eine SD-Phase gemäß obiger Erläuterung aktiviert werden kann, (d.h. durch Umschalten eines der drei Schalter S1, S2, S3 aus der ersten Schaltstellung 1 in die zweite Schaltstellung 2).

Figur 3 zeigt für einen kurzen zeitlichen Ausschnitt beispielhaft die Verläufe der an dem Messwiderstand Rs abfallenden Spannungen und somit die Verläufe der drei Motorströme I1, I2, I3 an den drei Motoranschlüssen U, V bzw. W.

Die Breite der drei in Figur 3 gezeigten Kurvenverläufe der Motorströme I1, I2, I3 gibt jeweils einen Hinweis auf das Absinken der Motorströme während derjenigen beiden (anderen) Chopper-Phasen, während der der jeweilige Motorstrom gerade nicht gesteuert wird. Ausgehend von Figur 2 bedeutet dies, dass z.B. die Breite des Kurvenverlaufes des ersten Motorstroms I1 durch das Absinken dieses ersten Motorstroms I1 während der zweiten und der dritten Chopper-Phase gemäß Figur 2(B) bzw. 2(C) verursacht wird. Entsprechendes gilt für das Absinken des zweiten Motorstroms 12 während der ersten und der dritten Chopper-Phase sowie das Absinken des dritten Motorstroms 13 während der ersten und der zweiten Chopper-Phase.

Dieses Absinken wird im Wesentlichen durch den jeweiligen Motor-Innenwiderstand verursacht und ist deshalb proportional zum Betrag des jeweiligen Motorstroms, d. h. im Bereich von dessen Nulldurchgang (d.h. hier entlang der mit x markierten Achse) geringer als im Bereich von dessen maximaler Amplitude. Ferner zeigen die Motorstromverläufe in den Schnittpunkten zweier Motorströme (von denen in Figur 3 zwei mit "S" markiert sind) jeweils geringfügige Verzerrungen.

Dies kann mehrere Gründe haben. Zum einen haben die Schalttransistoren, mit denen die Chopper-Phasen geschaltet werden, einen endlichen Innenwiderstand, der insbesondere in dem Fall, in dem zwischen zwei Chopper-Phasen eine äußere SD-Phase (Schalterstellungen 2 in Figur 2) geschaltet wird, zu einer Kopplung der drei Motorströme I1, 12, 13 führen kann.

Zum anderen sinkt der Motorstrom während der äußeren SD-Phasen aufgrund des Kurzschlusses des Motors und damit auch der Motorspulen sowie deren endlichen Innenwiderstandes in durch den Chopper-Algorithmus nicht kontrollierter Weise ab, was ebenfalls eine Kopplung der Motorströme I1, 12, 13 mit sich bringen kann.

Schließlich sind die Motorstromverläufe auch geringfügig über die sich gegenseitig beeinflussenden Längen der jeweiligen Chopper-Phasen miteinander gekoppelt. Der Grund für diese Kopplung liegt darin, dass in dem Fall, in dem eine Chopper-Phase relativ lang ist, auch eine der drei Motorspulen sich für diese relativ lange Zeitdauer in der SD-Spulenstromphase befindet und der Strom in dieser Spule dabei entsprechend stärker absinkt, sodass die nächste Chopper-Phase, in der diese Spule in der ON-Phase betrieben wird, möglicherweise, d.h. je nach Höhe des momentanen Motorstrom-Sollwertes, entsprechend länger sein muss.

Insgesamt können einer oder mehrere dieser Effekte zu einer gewissen Verkopplung jeweils zweier Motorströme an ihrem Schnittpunkt S führen, die sich in einer Verzerrung, insbesondere einer Abflachung und einem partiell parallelen Verlauf der beiden Motorströme auswirkt. Auch wenn dieser Effekt in einer realen Umgebung wie in der Figur 3 gezeigt messtechnisch kaum erkennbar ist, so kann er doch den Lauf des Motors spürbar nachteilig beeinflussen, da jede Abweichung von der idealen Motorstromform Resonanzen anregen kann.

Zur Vermeidung dieser Verzerrungen wird gemäß einer bevorzugten Ausführungsform der Erfindung der zugeführte, vorzeichenbehaftete Motor-Sollstrom IsU, IsV, IsW für den ersten, den zweiten bzw. den dritten Motoranschluss U, V, W jeweils um eine Hysterese erhöht, d.h. im Fall eines positiven Stromwertes (d.h. während des ersten und zweiten Quadranten bei sinusförmigem Strom) in Richtung der positiven Polarität erhöht und im Falle eines negativen Wertes (d.h. während des dritten und vierten Quadranten bei sinusförmigem Strom) um diese Hysterese in positiver Richtung vermindert, sodass die drei in Figur 2 gezeigten Chopper-Phasen jeweils erst dann beendet werden, wenn der jeweilige tatsächliche momentane Motorstrom I1, I2, I3 den momentanen Betragswert des Sollstroms IsU, IsV, IsW plus bzw. minus des Hysteresewertes erreicht hat und somit betragsmäßig jeweils etwas höher bzw. niedriger ist als der Betrag des betreffenden Wertes des Sollstroms. Die Hysterese wird dabei so gewählt, dass der mittlere tatsächliche Motorstrom I1, 12, 13 an jedem Motoranschluss U, V bzw. W infolge des (in entgegen gesetzter Richtung gerichteten) Absinkens der Strombeträge während der äußeren SD-Phasen (d.h. Schalterstellungen 2 in Figur 2) im Mittel den gewünschten Sollwerten IsU, IsV, IsW entspricht.

Mit anderen Worten wird also z.B. in dem Fall, in dem während einer Chopper-Phase gemäß Figur 2 (d.h. Schalterstellungen 1) ein positiver Motorstrom in einen Motoranschluss eingespeist wird, dieser Strom auf einen der Hysterese entsprechenden Wert oberhalb des betreffenden Sollwertes geregelt. Wenn dieser gleiche Motorstrom dann zu einem späteren Zeitpunkt einen negativen Wert hat und wiederum die betreffende Chopper-Phase aktiviert ist, so wird der Strom auf einen um die Hysterese betragsmäßig reduzierten Wert unterhalb des betreffenden Sollwertes geregelt.

Auf diese Weise kann erreicht werden, dass sich die gegenseitige Beeinflussung der Motorströme weniger stark ausprägt, so dass der mittlere Motorstrom I1, 12, I3 an jedem Motoranschluss U, V, W dadurch wesentlich genauer dem betreffenden vorgegebenen Sollstrom IsU, IsV, IsW folgen kann.

Mit den SD-Motorstromphasen (Schalterstellungen 2 in Figur 2) kann in erster Linie die Frequenz der drei in Figur 2(A), (B), (C) gezeigten Chopper-Phasen (Chopperfrequenz) vermindert werden, sodass diese auch unabhängiger von der Hystereseeinstellung wird. Die Chopperfrequenz kann auch durch Erhöhung der Hysterese vermindert werden. Allerdings sollte dabei ggf. darauf geachtet werden, dass die Chopperfrequenz nicht so stark vermindert wird, dass sie in den hörbaren Bereich gelangt.

Figur 4 zeigt für einen kurzen zeitlichen Ausschnitt die Verläufe der am Messwiderstand Rs abfallenden Spannungen und somit die Verläufe der Ströme I1, I2, I3 an den drei Motoranschlüssen U, V bzw. W bei Einsatz einer solchen Hysterese. Im Vergleich zu Figur 3 sind die Breiten der drei Stromkurvenverläufe auf Grund der Hysterese zwar deutlich größer, die Mittelwerte dieser Stromkurvenverläufe sind jedoch wesentlich besser an die ideale Sinusform angenähert.

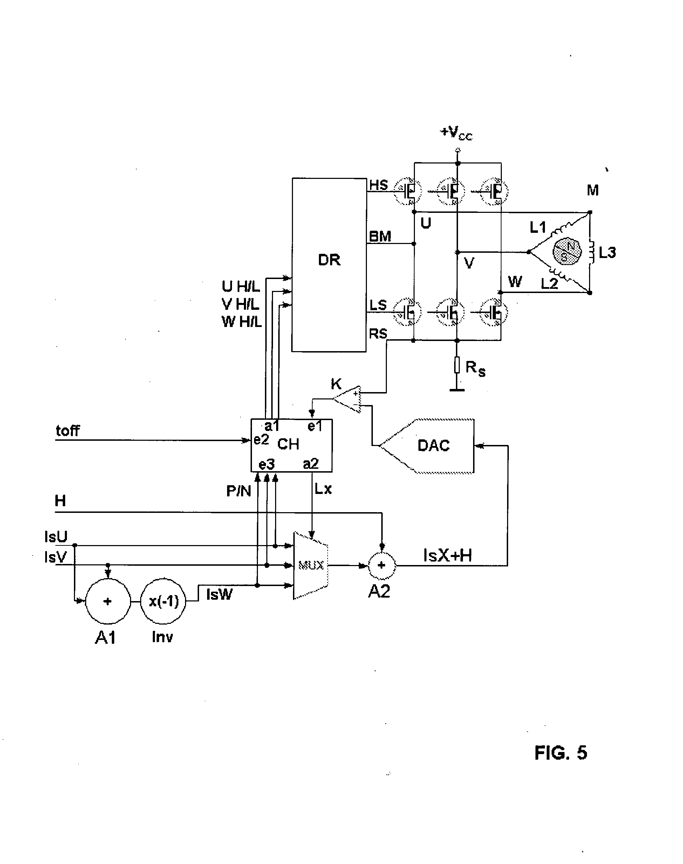

Figur 5 zeigt schließlich ein Blockschaltbild einer bevorzugten Schaltungsanordnung zur Durchführung des erfindungsgemäßen Verfahrens. Diese Schaltungsanordnung umfässt als an sich bekannte Komponenten eine Treiberschaltung DR, mit der über Ausgänge HS (High Side), LS (Low Side) und BM (Brückenmittelpunkt) eine Brückenschaltung mit Schalttransistoren (nicht bezeichnet) angesteuert wird, mit der durch PWM-Steuerung die Anschlüsse U, V, W eines 3-Phasen-Motors M entsprechend der Darstellung in Figur 2 und den diesbezüglichen obigen Erläuterungen der drei Chopper-Phasen (Schalterstellungen 1 in Figur 2) zyklisch mit der Versorgungsspannung Vcc bzw. über den Messwiderstand Rs mit Masse verbunden sowie ggf. die äußeren SD-Phasen (Schalterstellungen 2 in Figur 2) durch Verbinden aller drei Motoranschlüsse mit Masse aktiviert werden.

Wie bereits oben erwähnt wurde, wird der tatsächliche, in den oder aus dem jeweils mit der Versogungsspannung Vcc verbundenen Motoranschluss U, V, W und durch den Motor M fließende Strom I1, I2, I3 vorzugsweise mittels des Messwiderstandes Rs (und der an diesem dadurch abfallenden Spannung) im Fußpunkt der Brückenschaltungen erfasst.

Die Umschaltung von einer der Chopper-Phasen auf eine nächste Chopper-Phase, in der jeweils einer der Motoranschlüsse U, V, W mit der Versorgungspannung Vcc verbunden und die beiden anderen Anschlüsse kurzgeschlossen und über den Messwiderstand Rs mit Masse verbunden werden, erfolgt jeweils mit digitalen Schaltsignalen U H/L, V H/L, W H/L, die mit einem Chopper CH erzeugt und der Treiberschaltung DR zugeführt werden. Diese Schaltsignale bezeichnen die Richtungen H, L (positiv, negativ), in denen die Ströme I1, 12, 13 an den Motoranschlüssen U, V bzw. W zu erhöhen bzw. zu vermindern sind, um die jeweiligen Sollströme plus der Hysterese zu erreichen.

Die Aktivierung der äußeren SD-Phasen erfolgt über ein einem (zweiten) Eingang e2 des Choppers CH zugeführtes Signal zur Einstellung einer t_{OFF}-Zeit des Choppers, während der der Chopper über die Treiberschaltung DR alle Motoranschlüsse U, V, W auf Masse legt.

Die an dem Messwiderstand Rs abfallende, je nach Stromrichtung positive oder negative Spannung wird einem ersten Eingang eines Komparators K zugeführt, an dessen zweitem Eingang der Ausgang eines Digital/Analog-Wandlers DAC anliegt, mit dem die wie folgt beschrieben vorzugsweise in der digitalen Ebene erzeugten Zielstromwerte (d.h. die Sollstromwerte IsU, IsV, IsW an den Motoranschlüssen plus der Hysterese wie oben erläutert) vorzeichenbehaftet in analoge Werte umgewandelt werden (die Zielstromwerte könnten auch durch analoge Signalverabeitung erzeugt werden, dann ist der Digital/Analog-Wandler DAC natürlich überflüssig). Der Chopper CH erzeugt dann an einem ersten Ausgang a1 in Abhängigkeit von dem Ausgangssignal des Komparators K die der Treiberschaltung DR zugeführten digitalen Schaltsignale U H/L, V H/L, W H/L zur Umschaltung der Chopper-Phasen bzw. der (äußeren) SD-Phasen gemäß Figur 2 in der Weise, dass der jeweilige tatsächliche Motorstromverlauf I1, 12, 13 gemäß der obigen Beschreibung und wie in Figur 4 dargestellt dem betreffenden vorgegebenen Soll-Stromverlauf IsU, IsV, IsW entspricht.

Alternativ und analog zu der dargestellten Erfassung mittels eines Komparators K können die tatsächlichen Motorströme I1, I2, I3 auch über einen ADC (Analog/Digital-Wandler) erfasst werden, um die Signalverarbeitung vollständig in der digitalen Ebene vorzunehmen.

Der Chopper CH weist neben einem ersten Eingang e1 für das Ausgangssignal des Komparators K einen zweiten Eingang e2 zur Einstellung der optional zu verwendenden t_{OFF}-Zeit des Choppers und einen dritten Eingang e3 für eine jeweils vorgegebene momentane Richtung P/N (Polarität) der Soll-Spulenströme IsU, IsV, IsW auf. Über den dritten Eingang e3 wird das Umschalten dieser Polaritäten detektiert, um die Chopperaktivität mit den Polaritätswechseln zu synchronisieren, wodurch Schwebungen bei hohen Drehzahlen vermieden werden.

An einem zweiten Ausgang a2 des Choppers CH liegt ein Schaltsignal Lx zum Schalten eines Multiplexers MUX an. Den Eingängen des Multiplexers MUX werden die Soll-Motorströme IsU, IsV, IsW zugeführt, wobei sich (wie oben erläutert wurde) einer der drei Motorströme durch Addition der beiden anderen Motorströme und Invertierung von deren Summe ergibt. Zu diesem Zweck ist ein erster Addierer A1 sowie ein Inverter Inv vorgesehen. Mit dem Schaltsignal Lx wird der Multiplexer MUX zur Selektion jeweils eines der drei Soll-Motorströme IsU, IsV, IsW und damit zur Selektion der Chopper-Phasen gemäß Figur 2 zyklisch umgeschaltet, und zwar jeweils dann, wenn, wie oben mit Bezug auf Figur 2 erläutert wurde, der jeweilige momentane Motorstrom I1; I2; 13 den betreffenden momentanen Soll-Motorstrom IsU; IsV; IsW plus der Hysterese wie oben erläutert erreicht hat.

Die Schaltungsanordnung weist weiterhin einen zweiten Addierer A2 auf, mit dem ein über den Multiplexer MUX zugeführter momentaner (digitaler) Sollwert des Motorstroms IsU, IsV, IsW vorzugsweise mit einer zugeführten Hysterese H beaufschlagt wird.

Die momentanen digitalen Sollwerte der Motorströme IsU, IsV, IsW plus der Hysterese H werden dann dem Eingang des Digital/Analog-Wandlers DAC zugeführt, um daraus die momentanen analogen Sollwerte der Motorströme plus der Hysterese zu erzeugen, die dem zweiten Eingang des Komparators K zum Vergleich mit den gemessenen momentanen Motorstromwerten I1, 12, 13 zugeführt werden.

Wie bereits erwähnt wurde, erzeugt der Chopper CH dann in Abhängigkeit von dem Ausgangssignal des Komparators K die digitalen Schaltsignale U H/L, V H/L, W H/L für den Treiber DR so, dass dieser den betreffenden Motoranschluss U, V, W über eine PWM-Steuerung mit der Versorgungsspannung Vcc beaufschlagt und die betreffende Chopper-Phase beendet, wenn das Ausgangssignal des Komparators K im wesentlichen null ist und somit der tatsächliche Motorstrom an dem betreffenden Motoranschluss U, V, W mit dem zugehörigen Sollstrom IsU, IsV, IsW übereinstimmt. Zu diesem Zweck werden während zumindest zwei der drei Chopper-Phasen wie oben mit Bezug auf Figur 2 beschrieben wurde, die Motorstromphasen ON und FD und ggf. SD in durch den Chopper-Algorithmus bestimmter Weise aktiviert, bemessen und kombiniert. Wenn der Motorstrom nur während zwei der drei Chopper-Phase mittels der ON- bzw. FD-Motorstromphasen gesteuert wird, ergibt sich, wie in Figur 2 beispielhaft angegeben, der Motorstrom I3 während der dritten Chopper-Phase aus dem ersten und dem zweiten Motorstrom I1, 12.

Die Umschaltung zwischen den Chopper-Phasen, d.h. die Umschaltung zwischen den jeweiligen Motoranschlüssen U, V, W erfolgt mittels der Schaltsignale U H/L, V H/L, W H/L synchron mit der Auswahl des betreffenden Motor-Sollstroms IsU, IsV, IsW mittels des Schaltsignals Lx über den Multiplexer MUX, wobei die Frequenz dieser Umschaltung, wie oben erwähnt wurde, deutlich höher ist als die Frequenz der Motor-Sollströme IsU, IsV, IsW.

Alternativ oder zusätzlich zu der oben genannten Addition des Hysteresewertes mittels des zweiten Addierers A2 können die Zielstromwerte jeweils auch durch Beschaltung des Komparators K in der Weise erzeugt werden, dass dieser eine entsprechende Hysterese beim Vergleich der Stromsollwerte mit den tatsächlichen Stromwerten aufweist.

Die oben erläuterten Chopper-Phasen, die ON-, FD- und SD-Motorstromphasen sowie die weiteren oben beschriebenen Abläufe lassen sich in entsprechender Weise natürlich auch bei Motoren mit mehr als drei Phasen realisieren.

## Patentansprüche

1. Verfahren zur Regelung des Motorstroms bei einem elektrischen 3-Phasen-Motor, insbesondere einem 3-Phasen-Schrittmotor, mit einem ersten, einem zweiten und einem dritten Motoranschluss (U, V, W), wobei zyklisch alternierend jeweils eine erste, eine zweite und eine dritte Chopper-Phase aktiviert wird, während denen der Motor jeweils einerseits mit dem ersten, dem zweiten bzw. dem dritten Motoranschluss und andererseits mit den beiden jeweils anderen, miteinander verbundenen Motoranschlüssen zwischen eine Versorgungsspannung (Vcc) und Masse geschaltet ist, und wobei zumindest während zwei der drei Chopper-Phasen ein für den betreffenden ersten bzw. zweiten bzw. dritten Motoranschluss zugeführter Motor-Sollstrom (IsU; IsV; IsW) mittels eines Chopper-Verfahrens durch Aktivierung von Motorstromphasen (ON, FD) in diesen Motoranschluss (U, V, W) eingeprägt wird.

2. Verfahren nach Anspruch 1,
bei dem während einer Chopper-Phase entweder der eine Motoranschluss mit einer Versorgungsspannung und die beiden anderen, miteinander verbundenen Motoranschlüsse mit Masse, oder der eine Motoranschluss mit Masse und die beiden anderen, miteinander verbundenen Motoranschlüsse mit der Versorgungsspannung verbunden sind.

3. Verfahren nach Anspruch 1,
bei dem durch das Chopper-Verfahren zwischen zwei Chopper-Phasen eine SD-Motorstromphase dadurch aktiviert wird, dass alle drei Motoranschlüsse (U, V, W) miteinander verbunden werden.

4. Verfahren nach Anspruch 1,
bei dem während einer Chopper-Phase nur eine Motorstromphase (ON; FD) aktiviert wird.

5. Verfahren nach Anspruch 4,
bei dem eine Chopper-Phase dann beendet und die nächste Chopper-Phase aktiviert wird, wenn die Motorstromphase (ON; FD) in der betreffenden Chopper-Phase durch das Chopper-Verfahren beendet wird.

6. Verfahren nach Anspruch 1,
bei dem die Frequenz, mit der von einer auf eine nächste Chopper-Phase umgeschaltet wird, wesentlich höher ist, als die Frequenz der zugeführten Motor-Sollströme (IsU, IsV, IsW), und insbesondere bei mehreren 10 kHz liegt.

7. Verfahren nach Anspruch 1,
bei dem die Reihenfolge der Aktivierung der drei Chopper-Phasen in Übereinstimmung mit der Drehrichtung des Motors gewählt wird.

8. Verfahren nach Anspruch 1,
bei dem während jeder Chopper-Phase ein zugeführter momentaner Motor-Sollstrom (IsU; IsV; IsW) für den betreffenden Motoranschluss (U; V; W) mit einem tatsächlichen momentanen Motorstrom (I1; 12; I3) an diesem Motoranschluss verglichen und durch das Chopper-Verfahren in Abhängigkeit von einer Differenz zwischen diesen beiden Strömen ON- und FD-Motorstromphasen in an sich bekannter Weise so aktiviert, bemessen und kombiniert werden, dass der tatsächliche Motorstrom dem Motor-Sollstrom möglichst genau folgt.

9. Verfahren nach Anspruch 8,
bei dem der zugeführte momentane Motor-Sollstrom (IsU; IsV; IsW) um eine vorbestimmte Hysterese (H) erhöht wird, bevor er mit dem betreffenden tatsächlichen momentanen Motorstrom (I1; 12; 13) verglichen wird.

10. Schaltungsanordnung zur Regelung des Motorstroms bei einem elektrischen 3-Phasen-Motor, insbesondere einem 3-Phasen-Schrittmotor, mit einem ersten, einem zweiten und einem dritten Motoranschluss (U, V, W), insbesondere nach einem der vorhergehenden Ansprüche, mit einer durch einen Chopper (CH) angesteuerten Treiberschaltung (DR), mit der zyklisch alternierend zwischen mindestens zwei Chopper-Phasen umgeschaltet wird, wobei während jeder Chopper-Phase in jeweils einen der Motoranschlüsse mittels eines Chopper-Verfahrens ein einem zugeführten Motor-Sollstrom (IsU; IsV; IsW) für diesen Motoranschluss (U; V; W) entsprechender Motorstrom eingeprägt wird, wobei die beiden anderen Motoranschlüsse durch die Treiberschaltung (DR) miteinander verbunden sind.

11. Schaltungsanordnung nach Anspruch 10,
mit einem ersten Addierer (A1) sowie einem Inverter (Inv) zur Addition und Invertierung eines zugeführten ersten und zweiten Motor-Sollstroms (IsU, IsV) zur Erzeugung des dritten Motor-Sollstroms (IsW) gemäß der Formel IsW =- (IsU + IsV).

12. Schaltungsanordnung nach Anspruch 10,
mit einem Multiplexer (MUX) mit drei Eingängen, an denen jeweils der erste, der zweite bzw. der dritte Motor-Sollstrom (IsU, IsV, IsW) anliegt, sowie einem Ausgang, an den durch ein Chopper-Schaltsignal (Lx) zur Umschaltung zwischen den Chopper-Phasen jeweils einer der Eingänge anlegbar ist.

13. Schaltungsanordnung nach Anspruch 10,
mit einem Komparator (K) mit zwei Eingängen zum Vergleichen eines tatsächlichen Motorstroms (I1; I2; I3) mit einem zugeführten Motor-Sollstrom (IsU; IsV; IsW), sowie einem Ausgang, der mit dem Chopper (Ch) verbunden ist.

14. Schaltungsanordnung nach Anspruch 10,
mit einem zweiten Addierer (A2) zur Addition eines Hysteresewertes (H) zu den zugeführten Motor-Sollströmen (IsU; IsV; IsW).

15. Schaltungsanordnung nach Anspruch 10,
bei der mittels der durch den Chopper (CH) angesteuerten Treiberschaltung (DR) zwischen zwei Chopper-Phasen alle drei Motoranschlüsse (U, V, W) miteinander verbindbar sind.

## Claims

1. Method for controlling the motor current in an electrical 3-phase motor, especially a 3-phase stepper motor, comprising a first, a second and a third motor connection (U, V, W), wherein each a first, a second and a third chopper phase is cyclically alternating activated, wherein during each chopper phase the motor is connected on the one hand by means of one of the first, the second and the third motor connection, respectively, and on the other hand by means of the two other motor connections which are connected with each other, between a supply voltage (Vcc) and ground, and wherein during at least two of the three chopper phases a motor target current (IsU; IsV; IsW) which is supplied for the related one of the first, the second and the third motor connection, respectively, is injected into this motor connection (U, V, W) by activating of motor current phases (ON, FD) by means of a chopper process.

2. Method according to claim 1,
wherein during a chopper phase either the one motor connection is connected with the supply voltage and the other two motor connections which are connected with each other are connected to ground, or the one motor connection is connected with ground and the other two motor connections which are connected with each other are connected with the supply voltage.

3. Method according to claim 1,
wherein between two chopper phases an SD motor current phase is activated by the chopper process by connecting all three motor connections (U, V, W) with each other.

4. Method according to claim 1,
wherein during one chopper phase only one motor current phase (ON; FD) is activated.

5. Method according to claim 4,
wherein a chopper phase is terminated and a next chopper phase is activated, when the motor current phase (ON; FD) is terminated within the related chopper phase by the chopper process.

6. Method according to claim 1,
wherein a frequency of switching from one chopper phase to a next chopper phase is considerably higher than the frequency of the supplied motor target currents (IsU, IsV, IsW), and is especially in the range of several 10 kHz.

7. Method according to claim 1,
wherein the sequence with which the three chopper phases are activated is selected in coincidence with the rotational direction ofthe motor.

8. Method according to claim 1,
wherein during each chopper phase a supplied instantaneous motor target current (IsU; IsV; IsW) for the related motor connection (U; V; W) is compared with an actual instantaneous motor current (I1; I2; I3) at this motor connection, and wherein in dependence on a difference between both these currents ON- and FD- motor current phases are activated, dimensioned and combined by the chopper process in a known manner such that the actual motor current follows the motor target current almost precisely.

9. Method according to claim 8,
wherein the supplied instantaneous motor target current (IsU; IsV; IsW) is increased by a predetermined hysteresis (H), before it is compared with the related actual instantaneous motor current (I1; I2; I3).

10. Circuit arrangement for controlling the motor current in an electrical 3-phase motor, especially a 3-phase stepper motor, with a first, a second and a third motor connection (U, V, W), especially according to one of the preceding claims, comprising a driver circuit (DR) controlled by a chopper (CH), by which driver circuit a cyclic alternating switching is conducted between at least two chopper phases, wherein during each chopper phase a motor current is injected by means of a chopper process into each one of the motor connections, which motor current corresponds to a motor target current (IsU; IsV; IsW) supplied for this motor connection (U; V; W), wherein the two other motor connections are connected with each other by means ofthe driver circuit (DR).

11. Circuit arrangement according to claim 10,
comprising a first adder (A1) and an inverter (Inv) for adding and inverting a supplied first and second motor target current (IsU, IsV) for generating the third motor target current (IsW) according to the formula IsW =- (IsU + IsV).

12. Circuit arrangement according to claim 10,
comprising a multiplexer (MUX) with three inputs, to which the first, the second and the third motor target current (IsU, IsV, IsW), respectively, is applied, as well as an output, which can be connected to one of the inputs by means of a chopper switching signal (Lx) for switching between the chopper phases.

13. Circuit arrangement according to claim 10,
comprising a comparator (K) with two inputs for comparing an actual motor current (I1; I2; I3) with a supplied motor target current (IsU; IsV; IsW), as well as an output which is connected with the chopper (CH).

14. Circuit arrangement according to claim 10,
comprising a second adder (A2) for adding a hysteresis value (H) to the supplied motor target currents (IsU; IsV; IsW).

15. Circuit arrangement according to claim 10,
wherein between two chopper phases all three motor connections (U, V, W) can be connected with each other by means ofthe driver circuit (DR) which is controlled by the chopper (CH).

## Revendications

1. Procédé pour réguler le courant du moteur dans un moteur électrique triphasé, spécialement un moteur pas à pas triphasé, comprenant une première, une deuxième et une troisième connexion (U, V, W) du moteur, dans lequel chaque fois une première, une deuxième et une troisième phase de découpage est activée en alternance de façon cyclique, dans lequel pendant chaque phase de découpage le moteur est connecté d'une part au moyen d'une de la première, de la deuxième et de la troisième connexion du moteur respectivement, et d'autre part au moyen des deux autres connexions du moteur qui sont connectées l'une à l'autre, entre une tension d'alimentation (Vcc) et la terre, et dans lequel pendant au moins deux des trois phases de découpage un courant cible du moteur (IsU; IsV; IsW) qui est fourni pour la première, la deuxième et la troisième connexion relative du moteur respectivement, est injecté dans cette connexion du moteur (U, V, W) en activant des phases de courant du moteur (ON, FD) au moyen d'un processus de découpage.

2. Procédé selon la revendication 1,
dans lequel pendant une phase de découpage soit ladite une connexion du moteur est connectée à la tension d'alimentation et les deux autres connexions du moteur qui sont connectées l'une à l'autre sont connectées à la terre, soit ladite une connexion du moteur est connectée à la terre et les deux autres connexions du moteur qui sont connectées l'une à l'autre sont connectées à la tension d'alimentation.

3. Procédé selon la revendication 1,
dans lequel entre deux phases de découpage une phase de courant du moteur SD est activée par le processus de découpage en connectant les trois connexions du moteur (U, V, W) les unes aux autres.

4. Procédé selon la revendication 1,
dans lequel pendant une phase de découpage seule une phase de courant du moteur (ON; FD) est activée.

5. Procédé selon la revendication 4,
dans lequel une phase de découpage est terminée et une phase de découpage suivante est activée, lorsque la phase de courant du moteur (ON; FD) est terminée à l'intérieur de la phase de découpage y relative par le processus de découpage.

6. Procédé selon la revendication 1,
de découpage suivante est considérablement plus élevée que la fréquence des courants cibles du moteur fournis (IsU; IsV; IsW) et est spécialement de l'ordre de plusieurs dizaines de kHz.

7. Procédé selon la revendication 1,
dans lequel la séquence selon laquelle les trois phases de découpage sont activées est sélectionnée en coïncidence avec le sens de rotation du moteur.

8. Procédé selon la revendication 1,
dans lequel pendant chaque phase de découpage un courant cible du moteur instantané fourni (IsU; IsV; IsW) pour la connexion relative du moteur (U; V; W) est comparé avec un courant de moteur instantané réel (I1; I2; I3) à cette connexion du moteur, et dans lequel, en fonction d'une différence entre ces deux courants, des phases ON et FD de courant du moteur sont activées, dimensionnées et combinées par le processus de découpage d'une façon connue de telle manière que le courant de moteur réel suive presque précisément le courant cible du moteur.

9. Procédé selon la revendication 8, dans lequel le courant cible du moteur instantané fourni (IsU; IsV; IsW) est augmenté d'une hystérésis prédéterminée (H) avant qu'il soit comparé au courant du moteur instantané réel relatif (I1; I2; I3).

10. Dispositif pour réguler le courant du moteur dans un moteur électrique triphasé, en particulier un moteur pas à pas triphasé, avec une première, une deuxième et une troisième connexion du moteur (U, V, W), spécialement selon l'une quelconque des revendications précédentes, comprenant un circuit de commande (DR) régulé par un découpeur (CH), circuit de commande par lequel une commutation cyclique alternée est effectuée entre au moins deux phases de découpage, dans lequel pendant chaque phase de découpage un courant du moteur est injecté au moyen d'un processus de découpage dans chacune des connexions du moteur, courant du moteur qui correspond à un courant du moteur cible (IsU; IsV; IsW) fourni pour cette connexion du moteur (U; V; W), dans lequel les deux autres connexions du moteur sont connectées l'une à l'autre au moyen du circuit de commande (DR).

11. Circuit selon la revendication 10,
comprenant un premier additionneur (A1) et un inverseur (Inv) pour additionner et inverser un premier et un deuxième courant du moteur cible fourni (IsU, IsV) pour générer le troisième courant du moteur cible (IsW) selon la formule IsW =- (IsU + IsV).

12. Circuit selon la revendication 10,
comprenant un multiplexeur (MUX) avec trois entrées, auxquelles le premier, le deuxième et le troisième courant du moteur cible (IsU, IsV, IsW) est respectivement appliqué, ainsi qu'une sortie, qui peut être connectée à l'une des entrées au moyen d'un signal de commutation de découpeur (Lx) pour la commutation entre les phases de découpage.

13. Circuit selon la revendication 10,
comprenant un comparateur (K) avec deux entrées pour comparer un courant du moteur réel (I1; I2; I3) avec un courant du moteur cible fourni (IsU; IsV; IsW), ainsi qu'une sortie qui est connectée au découpeur (CH).

14. Circuit selon la revendication 10,
comprenant un deuxième additionneur (A2) pour additionner une valeur d'hystérésis (H) aux courants du moteur cibles fournis (IsU; IsV; IsW).

15. Circuit selon la revendication 10,
dans lequel, entre deux phases de découpage, les trois connexions du moteur (U, V, W) peuvent être connectées les unes aux autres au moyen du circuit de commande (DR) qui est régulé par le découpeur (CH).
